(19) Europäisches Patentamt
European Patent Office
Office européen des brevets

(11) **EP 1 641 205 B1**

(12) **EUROPÄISCHE PATENTSCHRIFT**

(45) Veröffentlichungstag und Bekanntmachung des Hinweises auf die Patenterteilung:
**06.10.2010 Patentblatt 2010/40**

(51) Int Cl.:
***H04L 27/152*** *(2006.01)* ***H03L 7/085*** *(2006.01)*

(21) Anmeldenummer: **05018145.2**

(22) Anmeldetag: **22.08.2005**

(54) **Schaltung und Verfahren zur Trägerrückgewinnung**

Apparatus und method for carrier recovery

Appareil et procédé pour la récupération de la porteuse

(84) Benannte Vertragsstaaten:
**DE FR GB IT NL**

(30) Priorität: **28.09.2004 DE 102004047424**

(43) Veröffentlichungstag der Anmeldung:
**29.03.2006 Patentblatt 2006/13**

(73) Patentinhaber: **Trident Microsystems (Far East) Ltd.**
**Grand Cayman (KY)**

(72) Erfinder: **Steinbach, Ingo**
**79104 Freiburg (DE)**

(74) Vertreter: **Epping - Hermann - Fischer**
**Patentanwaltsgesellschaft mbH**
**Ridlerstrasse 55**
**80339 München (DE)**

(56) Entgegenhaltungen:
**EP-A- 1 487 166**

• **J. AMMER, M. SHEETS: "TIMING RECOVERY UNIT FOR A 1.6 MBPS DSSS RECEIVER"[Online] 12. Dezember 2000 (2000-12-12), Seiten 1-28, XP002448107 University of Berkeley, USA Gefunden im Internet: URL:http:// bwrc.eecs.berkeley.edu/People/G rad_Students/ msheets/ee225c/EE225c_final_a mmer_ sheets.pdf> [gefunden am 2007-08-24]**
• **WEI GAO ET AL: "All-Digital Reverse Modulation Architecture Based Carrier Recovery Implementation for GMSK and Compatible FQPSK" IEEE TRANSACTIONS ON BROADCASTING, IEEE SERVICE CENTER, PISCATAWAY, NJ, US, Bd. 42, Nr. 1, März 1996 (1996-03), Seiten 55-62, XP011006019 ISSN: 0018-9316**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

## EP 1 641 205 B1

**Beschreibung**

Die Erfindung bezieht sich auf ein Verfahren zur Trägerrückgewinnung für einen Synchron-Demodulator gemäß den oberbegrifflichen Merkmalen des Patentanspruchs 1 bzw. auf eine entsprechende Schaltung zur Trägerrückgewinnung gemäß den oberbegrifflichen Merkmalen des Patentanspruchs 6.

Zur Übertragung eines Signals über insbesondere eine Funkschnittstelle wird das Signal vor der Übertragung moduliert. Empfängerseitig wird eine Demodulation vorgenommen. Zur Demodulation des Signals mit Hilfe eines Synchron-Demodulators ist es notwendig, das Trägersignal bzwden Träger für das Signal zu rekonstruieren. Das empfangene Signal wird dann mit diesem rekonstruierten Träger mit Hilfe eines I/Q-Mischer in das Basisband gemischt und damit demoduliert. Um den Träger zu rekonstruieren wird im Rahmen einer'Trägerrückgewinnung ein Phasen-Regelkreis (PLL: Phase-Locked-Loop) aufgebaut. Dieser misst den aktuellen Phasenunterschied zwischen empfangenem und rekonstruiertem Träger, um daraus ein Regelkorrektursignal für die Phase zu berechnen, mit dessen Hilfe der rekonstruierte Träger nachgeführt wird.

Die maximale Geschwindigkeit des Phasen-Regelkreises, die sogenannte PLL-Bandbreite, ist begrenzt durch Laufzeiten, die innerhalb der Regelschleife auftreten. Solche Laufzeiten werden in der Regelungstechnik als Totzeit bezeichnet. Sie reduzieren die maximal möglichen Schleifenverstärkungen, bei denen das System noch stabil arbeitet. Enthält das empfangene Signal jedoch Komponenten, welche außerhalb der PLL-Bandbreite liegen, bleibt ein Restphasenfehler bestehen. Dieser bewirkt eine Senkung des Demodulationsgrades und führt dazu, dass das Signal fehlerhart demoduliert wird.

Nachteilhaft ist somit, dass durch einen solchen Restphasenfehler keine fehlerfreie Demodulation durchgeführt werden kann, weshalb eine entsprechend verbesserte Verfahrensweise bzw. Schaltung zur Trägerrückgewinnung vorzuschlagen ist.

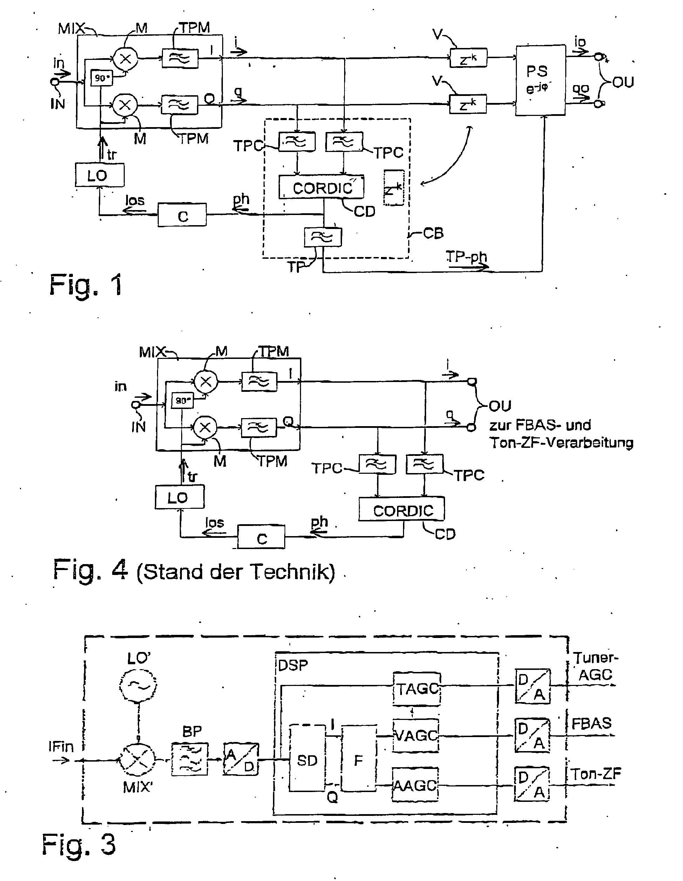

Fig.4 zeigt ein Blockschaltbild eines für sich bekannten Synchron-Demodulators. An einem Eingang IN eines I/Q-Mischers (I: Inphase, Q: Quadraturphase) liegt ein empfangenes Eingangssignal in an. Der Mischer MIX multipliziert das Eingangssignal in mittels zweier Multiplizierer M mit einem lokal rekonstruierten Bildträger bzw. Signalträger als Träger tr und mischt das Eingangssignal in dadurch in das Basisband. Beim Multiplizieren treten Mischprodukte auf, welche bei der doppelten Trägerfrequenz liegen. Diese Mischprodukte sind unerwünscht und werden daher innerhalb des Mischers MIX mit Hilfe von Tiefpassfiltern TPM ausgefiltert. Am Ausgang des Mischers MIX liegt der Träger auf einer Frequenz f=0. Ausgegeben wird entsprechend an einem Ausgang OU ein Mischsignal i, q mit einer inphasigen und einer quadraturphasigen Komponente I, Q.

Das Mischsignal i, q wird außerdem einem PLL-Regelkreis zugeführt. Nach nochmaliger Tiefpassfilterung in einem weiteren Tiefpassfilter TPC innerhalb des Regelkreises bzw. der Schleife zum Entfernen einer Toninformation im Fall eines Fernsehsignals wird das gefilterte Mischsignal einem sogenannten CORDIC (Koordinaten-Rotations-Digital-Computer/COordinate Rotation DIgital Computer) angelegt. Der CORDIC ermittelt durch Polarkoordinaten-Transformation den Phasenwert ph des I/Q-Signalpaars am Eingang. Ist der rekonstruierte Träger tr exakt gleich dem empfangenen Träger des Eingangssignals in, dann ist die gemessene Phase ph gleich Null. Ist dies nicht der Fall. dann wird die Phase ph dazu genutzu, um einen digitalen I/Q-Oszillator LO zu korrigieren. Dieser digitale I/Q-Oszillator LO erzeugt den Träger tr, welcher zum Mischen mit dem Eingangssignal in dem Mischer MIX zugeführt wird. Der Phasenwert ph wird dazu von dem CORDIC einer Steuereinrichtung C zugeführt, welche entsprechende Berechnungen durchführt und den Oszillator LO entsprechend ansteuert.

Die notwendigen Berechnungen innerhalb einer solchen Regelschleife, welche auch als ADPLL (All Digitäl PLL) bezeichnet wird, d.h. Berechnungen wie sie z.B. durch einen CORDIC-Algorithmus, die Filterung und die Berechnung eines Korrektursignals der Steuereinrichtung C durchgeführt werden, führen bei der Realisierung als Digitalschaltung durch die Berechnungszeit und durch Gruppenlaufzeiten der Filter zu Signalverzögerungen, welche in der Regelungstechnik als Totzeiten bezeichnet werden und welche die maximal mögliche Schleifenverstärkung und damit die Geschwindigkeit der Regelschleife reduzieren- Wird in einem solchen Fall eine zu große Schleifenverstärkung gewchlt, wird die Regelschleife instabil. Um die Geschwindigkeit einer ADPLL zu charakterisieren, benutzt man die PLL-Bandbreite, welche aus der System-Übertragungsfunktion erhalten wird. Sie gibt an, welche Frequenzänderungen noch ausgeregelt werden könnten.

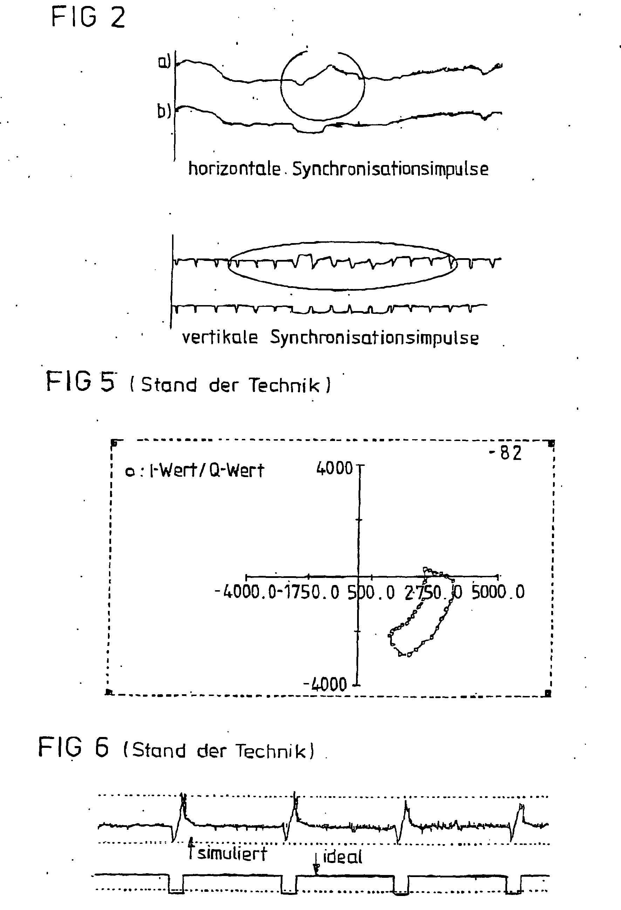

Fig.5 zeigt die Simulation eines Signals, in welchem der Bildträger eine unerwünschte Frequenzmodulation enthält. Die Frequenz des Bildträgers ändert sich dabei sehr schnell, sobald sich die Amplitude ändert. Da die Trägerrückgewinnung bei dieser Schaltungsanordnung nicht schnell genug reagieren kann, äußert sich die Frequenzänderung in einer Rotation, was bedeutet, dass der Phasenfehler immer größer wird, bis sich die Amplitude und damit auch die Frequenz wieder auf den ursprünglichen Zustand ändern.

Fig. 6 zeigt, dass das tatsächlich ausgegebene demodulierte Signal ein Verhalten zeigt, welches deutlich vom idealen Verhalten abweicht. Bei dem beispielhaften Signal handelt es sich um ein Videosignal mit schwarzem Bildinhalt. Die horizontalen Synchronisationsimpulse eines idealen Signals wären rechteckförmig und frei von hochfrequenten Rauschkomponenten. Das simulierte demodulierte Signal zeigt hingegen einen hohen Rauschanteil und schräg verlaufende Flanken mit starken hochfrequenten Schwingungskomponenten. Diese Verzerrungen der Synchronisationsimpulse bedeuten für ein angeschlossenes Fernsehgerät, dass die horizontale Ausrichtung der Bildzeilen nicht exakt ermittelt werden kann und führt damit zu verzerrten Bildinhalten.

Als weiterer Stand der Technik werden die Veröffentlichungen

- J. AMMER, M. SHEETS: Timing Recovery unit for a 1.6 MBPS DSSS Receiver. In: Document XP002448107, University of Berkeley, USA, 12.12.2000, Seiten 1-28, sowie
- WIE GAO et al.: All-Digital Reverse Modulation Architecture Based Carrier Recovery Implementation for GMSK and Compatible FQPSK. In: IEEE Transactions on Broadcasting, IEEE Service Center, Piscatway, NJ, US, Bd. 42, Nr. 1, März 1996, Seiten 55-62

genannt.

Die Aufgabe der Erfindung besteht darin, ein Verfahren bzw. eine Schaltung zur Trägerrückgewinnung vorzuschlagen, welche den Restphasenfehler berücksichtigen, um eine verbesserte Trägerrückgewinnung zu ermöglichen.

Diese Aufgabe wird durch ein Verfahren zur Trägerrückgewinnung mit den Merkmalen des Patentanspruchs 1 bzw. durch eine Schaltung zur Trägerrückgewinnung mit den Merkmalen des Patentanspruchs 6 gelöst.

Bevorzugt wird demgemäß ein Verfahren zur Trägerrückgewinnung für einen Synchron-Demodulator, bei dem ein Eingangssignal bereitgestellt wird, ein Träger für das bereitgestellte Eingangssignal rekonstruiert wird und das Eingangssignal und der Träger gemischt werden, um ein auszugebendes Mischsignal zu erzeugen, wobei zum Bereitstellen eines Ausgangssignals ein Bevorzugt wird demgemäß eine Schaltung zur Trägerrückgewinnung eines rekonstruierten Trägers für ein Eingangssignal mit einem Eingang zum Eingeben des Eingangssignals, einem Mischer, zum Mischen des Eingangssignals mit dem Träger, wobei ein Mischsignal bereitgestellt wird, und einem Phasen-Regelkreis zum Ermitteln eines Regelkorrektursignals zum Regeln des Trägers. Die Schaltung wird vorteilhaft durch einen Phasenschieber zum Korrigieren eines restlichen Phasenfehlers des Mischsignals zum Bereitstellen eines Ausgangssignals ergänzt.

Das Verfahren bzw. die Schaltung ermöglichen somit mit Hilfe des Restphasenfehlers die Trägerrückgewinnung derart zu erweitern, dass die Demodulation auch bei Signaländerungen außerhalb der PLL-Bandbreite störungsfrei oder zumindest deutlich verbessert durchgeführt werden kann.

Vorteilhafte Ausgestaltungen sind Gegenstand abhängiger Ansprüche.

Bevorzugt wird insbesondere ein Verfahren, bei welchem der restliche Phasenfehler innerhalb eines Regelkreises zur Messung der Phase des Mischsignals und zum Ermitteln eines Regelkorrektursignals zum Regeln des Trägers ermittelt wird.

Bevorzugt wird insbesondere ein solches Verfahren, bei welchem der restliche Phasenfehler innerhalb des Regelkreises ermittelt wird und für die Phasenverschiebung als nachträgliche Phasenverschiebung hinter dem Regelkreis verwendet wird.

Bevorzugt wird insbesondere ein Verfahren, bei welchem das Mischsignal vor der Phasenverschiebung verzögert wird entsprechend den Laufzeiten in dem Regelkreis.

Bevorzugt wird insbesondere ein Verfahren, bei welchem im Fall einer Regelung bei der Rekonstruktion des Trägers ein Phasenfehlerwert vor der Anwendung der Phasenverschiebung auf eine verwendete Abtastrate interpoliert wird.

Bevorzugt wird insbesondere ein Verfahren, bei welchem Parameter einer Tiefpassfilterung des restlichen Phasenfehlers gemäß einem Kompromiss aus Empfindlichkeit und Regelungsbandbreite einer Regelung bei der Rekonstruktion des Trägers festgelegt werden.

Bevorzugt wird insbesondere eine Schaltung, bei welcher der Phasen-Regelkreis zum Bestimmen des restlichen Phasenfehlers und Bereitstellen eines Korrektursignals für den Phasenschieber ausgebildet und/oder gesteuert ist.

Bevorzugt wird insbesondere eine Schaltung, bei welcher der Phasenschieber hinter einem Regel-Abgriff des Mischsignals für den Phasen-Regelkreis angeordnet ist.

Bevorzugt wird insbesondere eine Schaltung, bei welcher dem Phasenschieber eine Verzögerungseinrichtung vorgeschaltet ist zum Verzögern des Mischsignals vor dem Phasenschieber.

Bevorzugt wird insbesondere eine Schaltung mit einer Interpolationseinrichtung vor dem Phasenschieber zum Interpolieren eines Phasenfehlerwerts oder des Korrektursignals auf eine verwendete Abtastrate im Fall einer Unterabtastung im Phasen-Regelkreis.

Bevorzugt wird insbesondere eine Schaltung mit einem Tiefpassfilter zum Filtern des restlichen Phasenfehlers, eines Phasenfehlerwerts zum Bereitstellen des Korrektursignals, wobei die Parameter des Tiefpassfilters mittels einer Steuereinrichtung als Kompromiss aus Empfindlichkeit und Regelungsbandbreite festgelegt werden.

Die Erfindung wird nachfolgend anhand eines Ausführungsbeispiels näher erläutert. Es zeigen:

Fig. 1     eine bevorzugte Schaltung zur Trägerrückgewinnung unrer Berücksichtigung eines Restphasenfehlers;

Fig. 2    Simulazionsergebnisse, welche Kurven einer reinen PLL gegenüber einer PLL mit Korrektur des Restphasenfehlers zeigen;

Fig.3    ein Blockschaltbild eines digital realisierten Fernsehempfängers mit einer solchen Schaltung;

Fig. 4    ein Blockschaltbild eines Synchron-Demodulators zur Trägerrückgewinnung gemäß dem Stand der Technik;

Fig.5    eine Basisband-Darstellung eines frequenzmodulierten Fernsehsignal eines Synchron-Demodulators gemäß dem Stand der Technik; und

Fig.6    eine Darstellung eines demodulierten Videosignals bei frequenzmoduliertem Bildträger und langsamer Trägerrückgewinnung gemäß dem Stand der Technik.

Fig. 1 zeigt eine beispielhafte bevorzugte Schaltung zur Trägerrückgewinnung eines rekonstruierten Trägers für ein Eingangssignal in, insbesondere Fernseh-Eingangssignal in. Die einzelnen beschriebenen Komponenten können als einzelne und separate Bauelemente ausgestaltet sein. Möglich ist auch eine Umsetzung als integrierte Schaltung oder als Software in einem Prozessor, soweit dies für die einzelnen Komponenten realisierbar ist.
Einem Eingang IN der Schaltung wird das Eingangssignal in angelegt. Der Eingang IN entspricht zugleich einem ersten Eingang eines Mischers MIX. Das Eingangssignal in wird in dem Mischer zwei Multiplizierern M an deren jeweils ersten Eingang angelegt. An dem jeweils zweiten Eingang der Multiplizierer M wird ein Trägersignal tr in für sich bekannter Art und Weise derart angelegt, dass nach der Multiplikation des Eingangsignals in mit dem Träger tr ein inphasiges und ein quadraturphasiges Signal an dem jeweiligen Ausgang der Multiplizierer M ausgegeben wird. Diese multiplizierten Signale werden jeweils einem Tiefpassfilter TPM zugeführt. Die Ausgangssignale der Tiefpassfilter TPM werden einem inphasigen Ausgang I bzw. einem quadraturphasigen Ausgang Q als die Komponenten eines Mischsignals i, q zugeführt.
Das Mischsignal i, q wird in für sich bekannter Art und Weise dem Phasen-Regelkreis (PLL) zugeführt und einem ersten Verarbeitungsblock CB mit einem CORDIC CD zugeführt: Dabei werden die beiden Komponenten des Mischsignals i, q jeweils einem weiteren Tiefpassfilter TPC zugeführt, wenn im Fall z.B. eines Fernsehsignals eine Toninformation zu entfernen ist. Die Ausgangssignale der beiden Tiefpassfilter TPC werden dann dem eigentlichen CORDIC CD zur Verarbeitung in für sich bekannter Art und Weise zugeführt. Da für die nachfolgenden Betrachtungen der vom CORDIC CD bestimmte Phasenwert des I/Q-Signalpaares an dessen Eingang von Bedeutung ist, wird zur Vereinfachung lediglich dieser in Fig. 1 dargestellt und nachfolgend berücksichtigt. Weitere innerhalb einer solchen Schaltung übliche Signale oder auch Komponenten werden zu Vereinfachungszwecken nicht betrachtet und sind im Rahmen des üblichen Fachwissens hinzuzufügen.
Das von dem CORDIC CD ausgegebene Signal mit dem jeweils momentanen Phasenwert ph wird einer Steuereinrichtung C zugeführt, welche ein Regelkorrektursignal los für einen lokalen Oszillator LO erzeugt und bereitstellt. Der lokale Oszillator LO nutzt das Regelkorrektursignal los zum Anpassen des Trägers tr, welcher von dem lokalen Oszillator LO erzeugt und dem Mischer MIX zur Multiplikation mit dem Eingangssignal in zugeführt wird.
Das Signal mit dem Phasenwert ph, welches vom CORDIC CD ermittelt und ausgegeben wird, wird außerdem einem weiteren Tiefpassfilter TP zugeführt, um an dessen Ausgang ein Korrektursignal TP-ph zum Nachregeln des Trägers bereitzustellen. Dieses Korrektursignal TP-ph wird als Regelsignal einem Phasenschieber PS zugeführt, welcher zwei Eingänge zum Zuführen der Komponenten des Mischsignals i, q aufweist. Da durch den Regelkreis eine Laufzeitverzögerung $z^{-k}$ entsteht, wird das Mischsignal i, q zuvor mittels Verzögerungseinrichtungen V um einen entsprechenden Wert $Z^{-k}$ verzögert. Das Ausgangssignal bzw. dessen Komponenten der Verzögerungseinrichtungen V werden den beiden Eingängen des Phasenschiebers PS zugeführt. Der Phasenschieber PS sorgt mittels des angelegten Korrektursignals TP-ph zu einer Korrektur des restlichen Phasenfehlers des Mischsignals i, q und gibt an einen Ausgang OU ein korrigiertes Ausgangssignal io, qo aus. Der Phasenschieber ps kann je nach Ausgestaltung auch aus eigenständigen Komponenten für die beiden Signalkomponenten i, q des Mischsignals ausgestaltet sein.
Fig. 3 zeigt ein beispielhaftes Blockschaltbild eines digital realisierten Fernsehempfängers, in welchem eine solche Schaltung einsetzbar ist. Ein empfangenes Fernsehsignal IFin wird mit Hilfe eines lokalen Oszillators LO' und eines Mischers MIX' auf eine zweite Zwischenfrequenz umgesetzt. Nach Bandpassfilterung in einem Bandpassfilter BP sind unerwünschte Mischprodukte aus dem Signal entfernt und es kann ohne Aliasing in einem Analog/Digital-Wandler A/D digitalisiert werden. In einem nachfolgenden Digitalteil DSP zur digitalen Signalverarbeitung wird das diesen zugeführte Eingangssignal in zunächst mit Hilfe eines Synchron-Demodulators SD in das Basisband gemischt. Durch eine weitere Filterung in einem weiteren Filter F und verschiedene weitere Algorithmen werden aus dem vom Synchron-Demodulator SD ausgegebenen I/Q-Daten I, Q ein Videosignal und ein Ton-Zwischenfrequenz-Signal gewonnen- Mit Hilfe von Tuner AGC Automatic Gain Control/Auzomatische Verstärkungssteüerung) wird ein Tuner Ausgangspegel so eingestellt, dass der A/D-Wandler A/D nicht übersteuert wird- Ausgangsseitig werden mit Hilfe verschiedener für sich bekannter Komponenten VAGC (Video AGC) und AAGC (Audio AGC) auszugebende Signale für entsprechende D/A-Wandler (D/A: Digital/Analog) optimal ausgesteuert. Die D/A-Mandler geben entsprechende für sich bekannte Signale Tuner-AGC, FBAS (Farb-Bild-Austast-Synchron-Signal) bzw. Tvn-ZF (Ton-Zwischenfrequenz) an weitere Komponenten eines Fernsehempfängers aus.

Bei dieser Schaltungsanordnung eines digital realisierten Fernsehempfängers kann als der Synchron-Demodulator SD die Schaltungsanordnung gemäß Fig.1 vorteilhaft Eingesetzt werden, weiche als Ausgangssignale der inphasigen bzw. der quadraturphasigen Komponente I, Q das Ausgangssignal io, qo des Phasenschiebers PS ausgibt.

Der Syz.chran-Demodulator gemäß Fig. 1 kann auch in anderen Empfängersystemen vorteilhaft eingesetzt werden. Lediglich zur beispielhaften Beschreibung werden die theoretischen Grundlagen anhand des Empfangs von analogen Fernsehsignalen dargestellt. Das Eingangssignal am A/D-Wandler am Beispiel des analogen Fernsehens wird gebildet gemäß

$$u(t) = \hat{u}_{BT} \cdot \cos(2\pi f_{BT}(t) \cdot t) \cdot (1 + m \cdot U_{Bild}(t))$$
$$+ \hat{u}_{TT} \cdot \cos(2\pi f_{TT} \cdot t + \Delta\varphi_{TT} \cdot U_{Ton}(t)), \quad (1)$$

wobei der erste Term einer Bild-AM-Modulation und der zweite Term einer Ton-FM-Modulation, entspricht mit $\hat{u}_{BT}$ als einer Bildträgeramplitude, m als Modulationsindex, $U_{Bild}(t)$ als Bildinformation, $f_{BT}(t)$ als Bildträgerfrequenz, $\hat{u}_{TT}$ als Tonträgeramplitude, $f_{TT}$ als Tonträgerfrequenz, $\Delta\varphi_{TT}$ als Phasenhub der FM-Modulation und $U_{Ton}(t)$ als Toninformation.

Durch Filterung wird der Tonträger entfernt und das für die Trägerrückgewinnung relevante Signalmodell erhalten gemäß

$$u(t) = \hat{u}_{BT} \cdot \cos(2\pi f_{BT}(t) \cdot t) \cdot (1 + m \cdot U_{Bild}(t)) \quad (2)$$

als Bild-AM-Modulation.

Wie aus der Gleichung (2) ersichtlich, ist die Bildträgerfrequenz zeitlich "verändert. Sie kann sich rein zufällig verändern,. beispielsweise durch Phesenrauschen des Senders, oder abhängig von der Amplitude des Videosignals in Form einer zusätzlichen Frequenzmodulation.

Die für sich bekannte Trägerrückgewinnungsschleife wird, wie in Fig.1 dargestellt, durch eine Vorwärts-Steuerung erweitert, welche den restlichen Phasenfehler mit Hilfe des Phasenschiebers PS im eigentlichen Signalpfad hinter dem Mischer MIX und hinter dem Abgriff für den Regelkreis korrigiert. Dabei wird die System-Verzögerung $Z^{-k}$ der Filterung und der Phasenmessung im Signalpfad mittels der Verzögerungseinrichtungen V angepasst, damit am Eingang des Phasenschiebers PS zu jedem I/Q-Wertepaar des Mischsignals i, q der passende Phasenfehler gleichzeitig anliegt.

Der Phasenschieber PS kann beispielsweise durch den Einsatz des für sich bekannten CORDIC-Algorithmus realisiert werden. Eine Realisierung des Phasenschiebers PS ist auch durch eine komplexe Multiplikation mögliche welche ausführbar ist gemäß

$$I_{rot} + jQ_{rot} = (I_{in} + j\,Q_{in}) \cdot e^{-j\varphi}$$
$$= (I_{in} + j\,Q_{in}) \cdot (\cos\varphi - j\,\sin\varphi)$$
$$= (I\cos\varphi + Q\sin\varphi) + j(Q\cos\varphi - I\sin\varphi). \quad (3)$$

Das Korrektursignal TP-ph für den Phasenschieber PS wird, wie beschrieben, durch einen weiteren Tiefpassfilter TP im Vorwärts-Korrekturpfad aus dem Phasenwert ph erzeugt, welcher vom CORDIC CD ausgegeben wird. Mit Hilfe dieses Tiefpassfilters TP kann die Bandbreite der Fehlerkorrektur eingestellt werden.. Dies ist beispielsweise vorteilhaft, um breitbandiges Phasenrauschen des Sende-Oszillators von der Korrektur auszuklammern.

Um Rechenaufwand einzusparen, wird die Schleife des Regelkreises manchmal auf einer niedrigeren Abtastrate berechnet. In diesem Fall kann der weitere Tiefpassfilter TP zusätzlich oder alternativ als Inrerpolarionsfilter ausgelegt werden, um die ursprüngliche Abtastrate wieder zu erhalten.

Fig.2 zeigt Simulationsergebnisse einer Simulation des Gesamtsystems. Beispielhaft wird dabei ein demoduliertes Fernsehsignal, insbesondere FBAS-Signal, nach einer reinen Ausführung des Regelkreises (PLL) als erstes Signal a gegenüber einem zweiten Signal b mit einer zusätzlichen Korrektur des restlichen Phasenfehlers dargestellt. Hervorgehoben sind dabei die horizontalen Synchronisationsimpulse bzw. die vertikalen Synchronisationsimpulse, welche ohne den Einsatz der Vorwärtskarrektur als erste Signale a beide deutliche Verzerrungen zeigen, wodurch ein angeschlossenes Fernsehgerät kein stabiles Bild aus dem Signal erzeugen kann. Nach Aktivierung der Vorwärtskorrektur zeigen die gegenübergestellten zweiten Signale b korrekt demodulierte Synchronisationsimpulse.

**Patentansprüche**

1. Verfahren zur Trägerrückgewinnung für einen Synchron-Demodulator (SD), bei dem

   - ein Eingangssignal (in) bereitgestellt wird,
   - ein Träger (tr) für das bereitgestellte Eingangssignal (in) rekonstruiert wird,
   - das Eingangssignal (in) und der Träger (tr) gemischt werden, um ein auszugebendes Mischsignal (i, q) zu erzeugen und
   - zum Bereitstellen eines Ausgangssignals (io, qo) ein restlicher Phasenfehler des Mischsignals (i, q) mittels einer Phasenverschiebung korrigiert wird,

   wobei
   der restliche Phasenfehler (TP-ph) innerhalb eines Regelkreises zur Messung der Phase (ph) des Mischsignals (i, q) und zum Ermitteln eines Regelkorrektursignals (los) zum Regeln des Trägers (tr) ermittelt wird und eine Tiefpassfilterung (TP) des restlichen Phasenfehlers durchgeführt wird.

2. Verfahren nach Anspruch 1, bei welchem der restliche Phasenfehler innerhalb des Regelkreises ermittelt wird und für die Phasenverschiebung als nachträgliche Phasenverschiebung hinter dem Regelkreis verwendet wird.

3. Verfahren nach einem vorstehenden Anspruch, bei welchem das Mischsignal (i, q) vor der Phasenverschiebung verzögert wird entsprechend den Laufzeiten in dem Regelkreis.

4. Verfahren nach einem vorstehenden Anspruch, bei welchem im Fall einer Regelung bei der Rekonstruktion des Trägers ein Phasenfehlerwert (ph) vor der Anwendung der Phasenverschiebung auf eine verwendete Abtastrate interpoliert wird.

5. Verfahren nach einem vorstehenden Anspruch, bei welchem Parameter der Tiefpassfilterung des restlichen Phasenfehlers gemäß einem Kompromiss aus Empfindlichkeit und Regelungsbandbreite einer Regelung bei der Rekonstruktion des Trägers (tr) festgelegt werden.

6. Schaltung zur Trägerrückgewinnung eines rekonstruierten Trägers (tr) für ein Eingangssignal (in) mit

   - einem Eingang (IN) zum Eingeben des Eingangssignals (in),
   - einem Mischer (MIX, M) zum Mischen des Eingangssignals (in) mit dem Träger (tr), wobei ein Mischsignal (i, q) bereitgestellt wird,
   - einem Phasen-Regelkreis (MIX, CB, C, LO) zum Ermitteln eines Regelkorrektursignals (los) zum Regeln des Trägers (tr) und
   - einem Phasenschieber (PS) zum Korrigieren eines restlichen Phasenfehlers des Mischsignals (i, q) zum Bereitstellen eines Ausgangssignals (io, qo),

   wobei
   der Phasen-Regelkreis zum Bestimmen des restlichen Phasenfehlers und Bereitstellen eines Korrektursignals (TP-ph) für den Phasenschieber (PS) ausgebildet und/oder gesteuert ist und ein Tiefpassfilter (TP) zum Filtern des restlichen Phasenfehlers vorgesehen ist.

7. Schaltung nach Anspruch 6, bei welcher der Phasenschieber (PS) hinter einem Regel-Abgriff des Mischsignals (i, q) für den Phasen-Regelkreis angeordnet ist.

8. Schaltung nach einem der Ansprüche 6 oder 7, bei welcher dem Phasenschieber (PS) eine Verzögerungseinrichtung (V) vorgeschaltet ist zum Verzögern ($z^{-k}$) des Mischsignals (i, q) vor dem Phasenschieber (PS).

9. Schaltung nach einem der Ansprüche 6 bis 8 mit einer Interpolationseinrichtung (TP) vor dem Phasenschieber (PS) zum Interpolieren eines Phasenfehlerwerts (ph) oder des Korrektursignals (TP-ph), auf eine verwendete Abtastrate im Fall einer Unterabtastung im Phasen-Regelkreis.

**10.** Schaltung nach einem der Ansprüche 6 bis 9 mit einem Tiefpassfilter (TP) zum Filtern des restlichen Phasenfehlers, eines Phasenfehlerwerts (ph) zum Bereitstellen des Korrektursignals (TP-ph) wobei die Parameter des Tiefpassfilters (TP) mittels einer Steuereinrichtung als Kompromiss aus Empfindlichkeit und Regelungsbandbreite festgelegt werden.

**Claims**

**1.** Method for recovering a carrier for a synchronous demodulator (SD), comprising:

providing an input signal (in);
reconstructing a carrier signal (tr) for the provided input signal (in);
mixing the input signal (in) and the carrier signal (tr) in order to generate a mixed signal (i, q); and
correcting a residual phase error of the mixed signal (i, q) by means of a phase shift in order to provide an output signal (io, qo), wherein the residual phase error (TP-ph) is determined within a control loop for measuring the phase (ph) of the mixed signal (i, q) as well as determining a control correction signal (los) to control the carrier (tr), and wherein the residual phase error is filtered by a low-pass filter (TP).

**2.** The method of claim 1, where the residual phase error is determined within the control loop and is used for the application of the phase shift as posterior phase shift behind the control loop.

**3.** The method of any of the preceding claims, where the mixed signal (i,q) is delayed before the phase shift based on the propagation times within the control loop.

**4.** The method of any of the preceding claims, in which in the event of a control action during reconstruction of the carrier a phase error value (ph) is interpolated for an employed sampling rate before the application of the phase shift.

**5.** The method of any of the preceding claims, in which parameters of the residual phase error are defined based on a compromise between sensitivity and control bandwidth of a control action during reconstruction of the carrier (tr).

**6.** A circuit to effect carrier recovery of a reconstructed carrier (tr) for an input signal (in), comprising:

an input line (IN) for entering the input signal (in);
a mixer (MIX, M) to mix the input signal (in) with the carrier (tr) to provide a mixed signal (i, q);
a phase-locked loop (MIX, CB, C, LO) to determine a control correction signal (los) to control the carrier (tr); and
a phase shifter (PS) to correct a residual phase error of the mixed signal (i, q) to provide a phase corrected output signal (io, qo), wherein the phase-locked loop determines the residual phase error and provides a phase correction signal (TP-ph) to the phase shifter (PS), and a low-pass filter (TP) to filter the residual phase error is provided.

**7.** The circuit of claim 6, in which the phase shifter (PS) is arranged in such a way that the phase-locked loop receives the mixed signal (i, q).

**8.** The circuit of claims 6 or 7, comprising a delay device (V) that receives the mixed signal (i, q) and delays ($z^{-k}$) the mixed signal (i, q) before the phase shifter (PS).

**9.** The circuit of claims 6 to 8, comprising an interpolation device (TP) before the phase shifter (PS) to interpolate a phase error value (ph) or the correction signal (TP-ph) for an employed sampling rate in the event of undersampling in the phase-locked loop.

**10.** The circuit of claims 6 to 9, comprising a low-pass filter (TP) to filter the residual phase error, a phase error value (ph) to provide the correction signal (TP-ph), wherein the parameters of the low-pass filter (TP) are defined by a control device as a compromise between sensitivity and control bandwidth.

**Revendications**

**1.** Procédé de récupération de porteuse pour un démodulateur synchrone (SD), dans lequel

- un signal d'entrée (in) est fourni,
- une porteuse (tr) est reconstituée pour le signal d'entrée (in) fourni,
- le signal d'entrée (in) et la porteuse (tr) sont mélangés pour générer un signal mixte (i, q) à sortir et,
- en vue de la fourniture d'un signal de sortie (io, qo), une erreur de phase résiduelle du signal mixte (i, q) est corrigée moyennant un déphasage,

l'erreur de phase résiduelle (TP-ph) étant déterminée au sein d'une boucle d'asservissement servant à mesurer la phase (ph) du signal mixte (i, q) et à déterminer un signal de correction d'asservissement (los) en vue de l'asservissement de la porteuse (tr), et un filtrage passe-bas (TP) de l'erreur de phase résiduelle étant effectué.

2. Procédé selon la revendication 1, dans lequel l'erreur de phase résiduelle est déterminée au sein de la boucle d'asservissement et utilisée pour le déphasage comme déphasage ultérieur en aval de la boucle d'asservissement.

3. Procédé selon l'une des revendications précédentes, dans lequel le signal mixte (i, q) est retardé avant le déphasage conformément aux durées d'exécution dans la boucle d'asservissement.

4. Procédé selon l'une des revendications précédentes, dans lequel, en cas d'asservissement lors de la reconstitution de la porteuse, une valeur d'erreur de phase (ph) est interpolée à un taux de balayage utilisé avant l'application du déphasage.

5. Procédé selon l'une des revendications précédentes, dans lequel des paramètres du filtrage passe-bas de l'erreur de phase résiduelle sont définis selon un compromis entre sensibilité et largeur de bande d'un asservissement lors de la reconstitution de la porteuse (tr).

6. Circuit de récupération d'une porteuse reconstituée (tr) pour un signal d'entrée (in), comportant :

- une entrée (IN) pour entrer le signal d'entrée (in),
- un mélangeur (MIX, M) pour mélanger le signal d'entrée (in) avec la porteuse (tr), un signal mixte (i, q) étant fourni,
- une boucle d'asservissement de phase (MIX, CB, C, LO) pour déterminer un signal de correction d'asservissement (los) en vue d'asservir la porteuse (tr) et
- un déphaseur (PS) pour corriger une erreur de phase résiduelle du signal mixte (i, q) en vue de fournir un signal de sortie (io, qo),

la boucle d'asservissement de phase étant configurée et/ou commandée pour déterminer l'erreur de phase résiduelle et fournir un signal de correction (TP-ph) pour le déphaseur (PS) et un filtre passe-bas (TP) étant prévu pour filtrer l'erreur de phase résiduelle.

7. Circuit selon la revendication 6, dans lequel le déphaseur (PS) est disposé en aval d'une prise d'asservissement du signal mixte (i, q) pour la boucle d'asservissement de phase.

8. Circuit selon l'une des revendications 6 ou 7, dans lequel un dispositif de retardement (V) est connecté en amont du déphaseur (PS) en vue de retarder ($z^{-k}$) le signal mixte (i, q) en amont du déphaseur (PS).

9. Circuit selon l'une des revendications 6 à 8, comportant un dispositif d'interpolation (TP) en amont du déphaseur (PS) pour interpoler une valeur d'erreur de phase (ph) ou le signal de correction (TP-ph) à un taux de balayage utilisé dans le cas d'un sous-balayage dans la boucle d'asservissement de phase.

10. Circuit selon l'une des revendications 6 à 9, comportant un filtre passe-bas (TP) pour filtrer l'erreur de phase résiduelle, une valeur d'erreur de phase (ph) pour fournir le signal de correction (TP-ph), les paramètres du filtre passe-bas (TP) étant définis moyennant un dispositif de commande comme compromis entre sensibilité et largeur de bande d'asservissement.

Fig. 1

Fig. 4 (Stand der Technik)

Fig. 3

## FIG 2

horizontale . Synchronisationsimpulse

vertikale Synchronisationsimpulse

## FIG 5 (Stand der Technik)

o : I-Wert / Q-Wert

-82

4000

-4000.0 -1750.0 500.0 2750.0 5000.0

-4000

## FIG 6 (Stand der Technik)

↑ simuliert    ↓ ideal

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **J. AMMER ; M. SHEETS.** Timing Recovery unit for a 1.6 MBPS DSSS Receiver. *Timing Recovery unit for a 1.6 MBPS DSSS Receiver,* 12. Dezember 2000, 1-28

- All-Digital Reverse Modulation Architecture Based Carrier Recovery Implementation for GMSK and Compatible FQPSK. **WIE GAO et al.** IEEE Transactions on Broadcasting. IEEE Service Center, Marz 1996, vol. 42, 55-62